**Europäisches Patentamt**

**European Patent Office**

**Office européen des brevets**

(19)

(11) Veröffentlichungsnummer: **0 237 583**
**B1**

(12) # EUROPÄISCHE PATENTSCHRIFT

(45) Veröffentlichungstag der Patentschrift:
**29.11.89**

(51) Int. Cl.⁴: **H03M 1/48**

(21) Anmeldenummer: **86101578.2**

(22) Anmeldetag: **07.02.86**

(54) Verfahren und Schaltungsanordnung zum Umsetzen einer Messspannung in einen digitalen Wert.

(43) Veröffentlichungstag der Anmeldung:
**23.09.87 Patentblatt 87/39**

(45) Bekanntmachung des Hinweises auf die Patenterteilung:
**29.11.89 Patentblatt 89/48**

(84) Benannte Vertragsstaaten:
**DE GB**

(56) Entgegenhaltungen:
**DE-A- 2 260 441**
**DE-A- 2 952 311**
**US-A- 3 673 395**

(73) Patentinhaber: **HOTTINGER BALDWIN MESSTECHNIK GMBH, Im Tiefen See 45 Postfach 42 35, D-6100 Darmstadt(DE)**

(72) Erfinder: **Kreuzer, Manfred, Georg Büchner-Strasse 6b, D-6108 Weiterstadt(DE)**

(74) Vertreter: **Brandt, Ernst-Ulrich, Hottinger Baldwin Messtechnik GmbH Patentabteilung Im Tiefen See 45 Postfach 42 35, D-6100 Darmstadt(DE)**

## Beschreibung

Die Erfindung betrifft ein Verfahren und Schaltungsanordnung zum Umsetzen mindestens einer Meßspannung in einen digitalen Wert nach dem Nachlaufprinzip, bei dem zum Meßsignal ein Kompensationssignal addiert wird, so daß im Abgleichsfalle das Nullsignal, dargestellt durch den Mittelwert der Summe aus Meßsignal und Kompensationssignal, zu Null wird, wobei das Kompensationssignal aus mindestens zwei Hilfskompensationsgrößen gebildet wird, die Rechtecksignale mit fester Frequenz und unabhängig voneinander einstellbaren Tastverhältnissen sind und deren Tastverhältnisse bei Abweichen des Nullsignals von Null derart verändert werden, daß das Nullsignal wieder nach Null geht, sowie eine Schaltungsanordnung zur Durchführung des Verfahrens. Ein derartiges Verfahren und eine hierfür geeignete Schaltungsanordnung sind aus der DE-A1 2 952 311 bekannt.

Es ist Aufgabe der Erfindung, ein Verfahren und eine Schaltungsanordnung zu schaffen, bei welchen gegenüber dem Stand der Technik bei sehr geringem Schaltungsaufwand wesentlich höhere Nachstellgeschwindigkeiten und kürzere Einschwingzeiten erreicht werden.

Die Lösung dieser Aufgabe erfolgt bei einem Verfahren gemäß dem Oberbegriff des Patentanspruches 1 mit den im kennzeichnenden Teil dieses Anspruches und bei einer Schaltungsanordnung gemäß dem Oberbegriff des Patentanspruches 5 mit den im kennzeichnenden Teil des Patentanspruches 5 angegebenen Maßnahmen. Die weiteren Patentansprüche beziehen sich auf zweckmäßige Ausgestaltungen des Verfahrens bzw. der Schaltungsanordnung.

In der nachfolgenden Beschreibung wird die Erfindung anhand der in den Zeichnungen schematisch dargestellten Ausführungsbeispiele erläutert. Es zeigen:

Fig. 1 eine prinzipielle Schaltungsanordnung zur Durchführung des Verfahrens,

Fig. 2 eine besonders einfache Ausführung des Analog-Digital-Umsetzers 2.2 in Fig. 1,

Fig. 3 den Spannungsverlauf beim Analog-Digital-Umsetzer gemäß Fig. 2 und

Fig. 4 eine detailliertere Darstellung der Schaltungsanordnung gemäß Fig. 1.

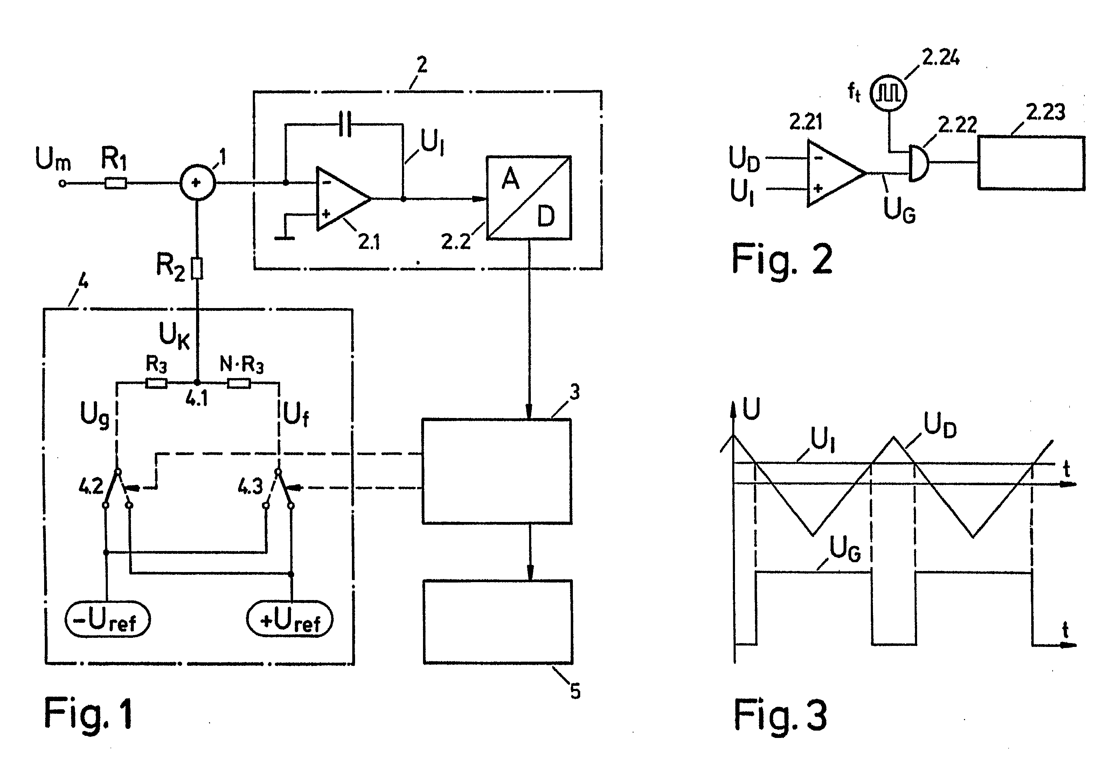

In Fig. 1 werden dem Kompensationspunkt 1 über den Widerstand $R_I$ die Meßspannung um und über den Widerstand $R_2$ eine Kompensationsspannung $U_K$ zugeführt, dort addiert und auf den negativen Eingang eines in einem Nullverstärker 2 befindlichen Integrators 2.1 gegeben. Ist der Mittelwert des Signals am Kompensationspunkt 1 und damit am Eingang des Integrators 2.1 ungleich Null, so ändert sich dessen Ausgangsspannung $U_I$. Die Spannung $U_I$ wird im Analog-Digital-Umsetzer 2.2 des Nullverstärkers 2 in einen entsprechenden Digitalwert umgesetzt, der von einem digital arbeitenden PI- oder PID-Regler, nachfolgend kurz als Regler 3 bezeichnet, abgefragt wird. Der Regler 3 bildet den Nullabgleichwert, indem er vom Digitalwert einen vorgegebenen Digitalwert – in der Regel den Wert Null – abzieht. Den Nullabgleichwert bewertet der Regler 3 mit seinen Proportional(P)-, Integral(I)- und gegebenenfalls Differential(D)-Algorithmen, addiert die PI- bzw. PID-Ergebnisse und stellt die Tastverhältnisse der Schalter 4.2 und 4.3 in einem Stellglied 4 auf den PI- bzw. PID-Wert ein. Dabei werden die Stellen hoher Wertigkeit durch den Schalter 4.2 und die Stellen niedriger Wertigkeit durch den Schalter 4.3 dargestellt.

Die Schalter 4.2 und 4.3 werden mit konstanter Frequenz $f_T$ aber variablen Tastverhältnissen zwischen den beiden Referenzspannungen $-U_{ref}$ und $+U_{ref}$ umgeschaltet. Die beiden Tastverhältnisse werden durch Zählen einer höheren Frequenz $f_t$ gebildet, die ein ganzzahliges Vielfaches der Schaltfrequenz $f_T$ ist.

An den Schaltern 4.2 bzw. 4.3 entstehen generierte Rechteckspannungen $U_g$ bzw. $U_f$ mit Mittelwerten, die sich durch Verändern ihrer Tastverhältnisse proportional zu ihrem jeweiligen Tastverhältnis zwischen $-U_{ref}$ und $+U_{ref}$ einstellen lassen. Die beiden Spannungen $U_g$ und $U_f$ werden mit Hilfe der Widerstände R3 und N x R3 im Verhältnis N bewertet und bilden die Kompensationsspannung $U_K$, wobei der Bewertungsfaktor

$$N = \frac{U_g}{U_f}$$

ist. Beispielsweise ergeben sich für $f_T$ = 1 KHz, $f_t$ = 1 MHz, einen PI- bzw. PID-Wert = 435.783 und einen Bewertungsfaktor N = 1 000 für den Schalter 4.2 ein Tastverhältnis von 1 000 : 435 und für den Schalter 4.3 ein Tastverhältnis von 1 000 : 783.

Die Tastverhältnisse werden solange nachgestellt, bis der Mittelwert der Summenspannung am Kompensationspunkt 1 zu Null wird. In diesem Zustand ist

$$U_m = - \frac{R1}{R2} \text{ x } U_K$$

Da R1 und R2 bekannt sind und die Kompensationsspannung $U_K$ durch die beiden Tastverhältnisse von $U_g$ und $U_f$ bestimmt ist, kann auch die Meßspannung $U_m$ mit hoher Auflösung ermittelt werden. In einem Anzeigegerät 5 wird der betreffende Integralwert I vom Regler 3 als Maß für den Meßwert zur Anzeige gebracht.

Die Proportional(P)-Anteile sind für das Stellglied 4 aus Stabilitätsgründen erforderlich. Die Verwendung lediglich eines Integral(I)-Reglers würde zusammen mit dem Integrator 2.1 im Nullverstärker 2 eine 180° Phasenbedingung und damit Instabilität erzeugen. Besitzt der Regelkreis zusätzlich zum Integrator noch weitere Elemente und Funktionen, die Lauf- oder Totzeiten bewirken (z. B. Filter- und Regler-Rechenzeiten), so sind zur optimalen Regelkreiseinstellung, z. B. um ein aperiodisches Einschwingenverhalten zu erreichen, zusätzliche Differential(D)-Anteile zur Stabilisierung erforderlich.

Die beiden in ihrem Tastverhältnis veränderbaren Spannungen $U_g$ (Grobspannung) und $U_f$ (Feinspannung) besitzen eine unterschiedliche Wertigkeit in ihrem Einfluß auf die Kompensationsspannung $U_K$. Die Wertigkeiten verhalten sich wie $W_g : W_f = N : 1$. Läßt sich das Tastverhältnis der Spannungen $U_g$ und $U_f$ beispielsweise in T/1000 Schritten verändern und wird das Verhältnis der Wertigkeiten mit N = 1000 gewählt, so kann der Mittelwert der Kompensationsspannung $U_K$ mit $10^6$ Schritten, d.h. mit sehr hoher Auflösung verändert werden.

Wird zur Auszählung der Tastverhältnisse der geschalteten Rechteckspannungen $U_g$ und $U_f$ eine technisch mögliche hohe Frequenz von 100 MHz gewählt, so ergibt sich eine Meßfolge von 100 KHz, d.h. alle 10 µs ist dann ein Digitalwert mit einer Auflösung von $10^6$d verfügbar. Damit wird eine von keinem bisher bekannten Analog-Digital-Umsetzverfahren erreichte Kombination von Auflösung und Meßfolge geschaffen.

Noch schnellere Meßfolgen und höhere Auflösungen des Digitalwerts sind erzielbar, wenn ein Stellglied mit mehr als den beschriebenen zwei Stufen verwendet, d.h. wenn zur Bildung der Kompensationsspannung $U_K$ drei oder mehr bewertete Rechteckspannungen mit unabhängig veränderlichen Tastverhältnissen herangezogen werden.

Mit der Erfindung kann eine praktisch unbegrenzt hohe Auflösung des Abgleichkreises erzielt werden, da auch kleinste Differenzen zwischen Meßsignal $U_m$ und Mittelwert des Kompensationssignals $U_K$ am Punkt 1 dazu führen, daß die Ausgangsspannung des Integrators 2.1 langsam aus Null auswandert, bis die Nullschwelle des Analog-Digital-Umsetzers 2.2 überschritten wird und er einen von Null abweichenden Wert an den digitalen Regler 3 abgibt, der dazu führt, daß das sehr hoch auflösende Stellglied um einen Schritt nachgestellt wird.

Sollen gelegentlich Meßsignale mit hohen dynamischen Signalanteilen erfaßt werden, so ist es auch möglich, die PI- oder PID-Koeffizienten des Reglers 3 zu vergrößern, um bei dann verringerter Auflösung eine Erhöhung der Meßsignal-Bandbreite zu erreichen. Höchste Signalbandbreiten lassen sich dann erreichen, wenn der Regler auf P- oder PD-Betriebsart umgeschaltet wird und als digitaler Meßwert der P-Wert verwendet wird. Allerdings ist dann die Auflösung stark reduziert; sie kann dann prinzipiell nicht größer als die Auflösung des Analog-Digital-Umsetzers 2.2 werden.

Werden in Abhängigkeit von dem Digitalwert des Analog-Digital-Umsetzers 2.2 die PID-Koeffizienten des Reglers 3 automatisch verändert, so führt dies zu einer nichtlinearen Regelung, mit deren Hilfe es möglich wird, einerseits bei langsamen bis mittleren stetigen Meßsignaländerungen einen Meßwert mit extrem hoher Auflösung und konstant hoher Meßrate zu ermitteln und andererseits bei sehr schnellen oder sprunghaften Meßsignaländerungen bei dann reduzierter Auflösung dem Meßsignal sehr schnell zu folgen.

Die Erfindung kann somit lediglich durch Ändern der Reglereigenschaften des Reglers 3 optimal an unterschiedliche Meßaufgaben, wie die Messung von Signalen mit höheren Frequenzanteilen oder die Messung von ste tig veränderlichen bzw. quasi statischen Signalen, angepaßt werden. An den Analog-Digital-Umsetzer 2.2 werden nur sehr geringe Genauigkeitsanforderungen gestellt, da er ja innerhalb des Reglerkreises liegt und bei den Betriebsarten PI oder PID des Reglers 3 im Abgleichsfall immer nur einen Nullwert abgeben muß und weder seine Nullpunkts- noch seine Empfindlichkeitsfehler einen Einfluß auf den Meßwert haben. Im einfachsten Falle käme der Analog-Digital-Umsetzer 2.2 daher mit den drei Ausgangszuständen Null, > Null, < Null aus. Regelungstechnisch günstiger ist es jedoch, wenn der Analog-Digital-Umsetzer 2.2 einen Digitalwert mit möglichst hoher Auflösung abgibt.

In Fig. 2 ist eine sehr einfache Ausführung des Analog-Digital-Umsetzers 2.2 gemäß Fig. 1 dargestellt, deren Arbeitsweise nachfolgend anhand von Fig. 3 erläutert wird.

Die im Pegel zwar veränderliche, kurzzeitig jedoch relativ konstante Spannung $U_I$ wird dem einen Eingang eines Komparators 2.21 zugeführt, an dessen anderen Eingang eine Dreieckspannung $U_D$ liegt. Der Komparator 2.21 erzeugt an seinem Ausgang eine Rechteckspannung $U_G$, deren Frequenz konstant und gleich der Frequenz der Dreieckspannung ist, deren Tastverhältnis sich jedoch linear mit der Spannung $U_I$ verändert. Durch Auszählen des Tastverhältnisses von $U_G$ kann ein digitaler Meßwert für die Spannung $U_I$ ermittelt weden. Zu diesem Zweck steuert der positive Spannungspegel von $U_G$ die Torschaltung 2.22 auf und läßt während dieser Zeit die Zählimpuse mit der Frequenz $f_t$ vom Taktgenerator 2.24 zum Zähler 2.23 durch. Wird für die Dreiecksfrequenz die Meßfolgefrequenz von 100 KHz entsprechend dem vorerwähnten Beispiel genommen und für die Taktfrequenz $f_t$ der 100 MHz-Takt, so kann aus dem Zähler 2.23 alle zehn µs ein Digitalwert in einem Bereich von +- 500 d ausgelesen werden. Die höchste Nachlaufgeschwindigkeit ergäbe sich somit mit 50 x $10^6$d/s. Der Gesamt-Umsetzbereich von $10^6$d könnte somit in minimal 20 ms durchlaufen werden. Falls der Regler 3 jedoch nicht linear reagiert, kann diese Zeit noch erheblich reduziert werden.

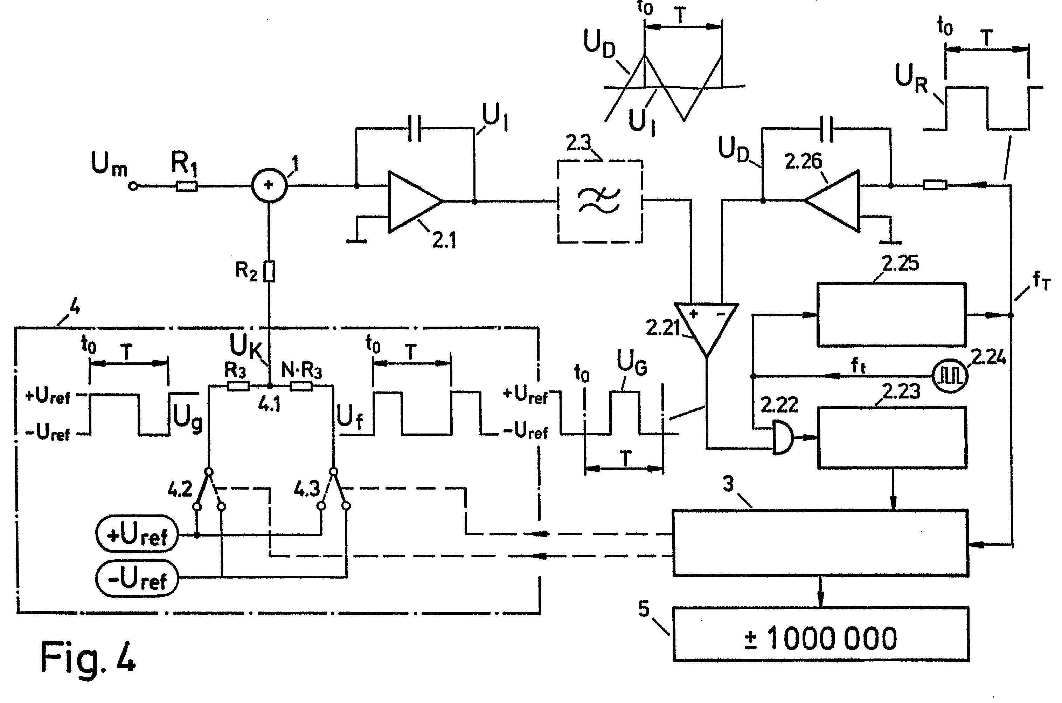

In Fig. 4 sind - soweit mit den Figuren 1 und 2 übereinstimmend - gleiche Teile mit denselben Bezugsziffern versehen. Zusätzlich enthält das Ausführungsbeispiel gemäß Fig. 4 einen Frequenzteiler 2.25, einen Integrator 2.26, der die Rechteckspannung $U_R$ in die Dreieckspannung $U_D$ umwandelt, und ein Tiefpaß 2.3. Der Integrator 2.26 kann in vielen Fällen durch ein RC-Glied ersetzt werden.

Der Frequenzteiler 2.25 teilt die Taktfrequenz $f_t$ ganzzahlig (z.B. entsprechend dem vorerwähnten Beispiel im Verhältnis 1 000 : 1) in die Rechteckspannung $U_R$ mit der Frequenz $f_T$ und der Periodendauer T herunter. Die Rechteckspannung $U_R$ wird zum einen dem Integrator 2.26 zugeführt, der daraus die Dreieckspannung $U_D$ bildet, und zum anderen stößt die positive Flanke von $U_R$ den Regler 3 an, der daraufhin mit der Frequenz $f_T$ den Zählerstand des Zählers 2.23 ausliest und die Schaltspannungen für die Schalter 4.2 und 4.3 erzeugt.

Der Tiefpaß 2.3 ist in Fig. 4 nur gestrichelt dargestellt, weil sein Einsatz nicht immer erforderlich ist. Er dämpft die dynamischen Anteile des Nullsignals zusätzlich zum Integrator 2.1 im Nullverstärker 2; daher kann bei Verwendung des Tiefpasses 2.3 die Zeitkonstante des Integrators 2.1 kürzer gewählt werden. Jedoch ist der Tiefpaß 2.3 so zu optimieren, daß kürzeste Abgleichzeiten der Gesamtschaltung erreicht werden.

## Patentansprüche

1. Verfahren zum Umsetzen mindestens einer Meßspannung in einen digitalen Wert nach dem Nachlaufprinzip, bei dem zum Meßsignal ($U_m$) ein Kompensationssignal ($U_K$) addiert wird, so daß im Abgleichsfalle das Nullsignal, dargestellt durch den Mittelwert der Summe aus Meßsignal und Kompensationssignal zu Null wird, wobei das Kompensationssignal aus mindestens zwei unterschiedlich bewerteten Hilfskompensationsgrößen ($U_g$, $U_f$) gebildet wird, die Rechtecksignale mit fester Frequenz und unabhängig voneinander einstellbaren Tastverhältnissen sind und deren Tastverhältnisse bei Abweichen des Nullsignals von Null derart verändert werden, daß das Nullsignal wieder nach Null geht, dadurch gekennzeichnet, daß

— bei konstantem Meßsignal ($U_m$) das Nullsignal annähernd ein Rechtecksignal in der Form des Summensignals der Hilfskompensationsgrößen ($U_g$, $U_f$) ist, jedoch derart, daß sein Mittelwert im anbgeglichenen Zustand Null ist, d.h die positiven und die negativen Anteile des Rechtecksignals über die Zeit in einem Integrator zu Null integriert werden,

— die Ausgangsspannung ($U_I$) des Integrators mit der festen Frequenz $f_T$ in einen Nullabgleichswert umgesetzt wird,

— der Nullabgleichswert einem digitalen PI- oder PID-Regler (3) zugeführt wird, der in bekannter Weise den Nullabgleichswert mit P-, I- und/oder D-Faktoren multipliziert und die Summe der Ergebnisse zum bereits vorhandenen Kompensationssignal addiert, und

— der als digitales Signal vorliegende I-Wert als Maß für die Meßspannung ($U_m$) herangezogen wird.

2. Verfahren nach Anspruch 1, dadurch gekennzeichnet, daß die PI- bzw. PID-Koeffizienten des Reglers (3) verändert werden, so daß je nach geforderter Auflösung die kürzesten Einschwingzeiten und größten Meßsignalbandbreiten erzielt werden.

3. Verfahren nach Anspruch 1 oder 2, dadurch gekennzeichnet, daß der Regler (3) nichtlinear betrieben wird, d.h. daß in Abhängigkeit von der Regelgröße seine PI- bzw. PID-Koeffizienten so verändert werden, daß er sehr schnellen Meßsignaländerungen mit hoher Geschwindigkeit bei verminderter Auflösung und langsameren Meßsignaländerungen mit entsprechend höherer Auflösung folgen kann.

4. Verfahren nach Anspruch 1, dadurch gekennzeichnet, daß der Regler (3) zur Erzielung höchster Meßsignalbandbreiten von PI- oder PID-Verhalten auf P- oder PD-Verhalten umgeschaltet und anstelle des Integralwertes der Proportionalwert des Reglers (3) als Meßwert herangezogen wird.

5. Schaltungsanordnung zur Durchführung des Verfahrens nach einem der vorhergehenden Ansprüche, dadurch gekennzeichnet, daß die Summe aus Meßsignal ($U_m$) und Kompensationssignal ($U_K$) am Eingang eines Integrators 2.1 anliegt, dessen Ausgang mit dem einen Eingang eines Komparators (2.21) verbunden ist, an dessen zweiten Eingang eine Dreiecksspannung ($U_D$) konstanter Amplitude und konstanter Frequenz ($f_T$) anliegt, daß der Ausgang des Komparators mit dem einen Eingang einer Torschaltung (2.22) verbunden ist, an deren anderen Eingang die Ausgangsspannung eines Oszillators (2.24) mit der Frequenz $f_T$ anliegt, daß der Ausgang der Torschaltung (2.22) mit dem Eingang eines Zählers (2.23) verbunden ist, dessen Digitalausgang mit einem Regler (3) in Verbindung steht, daß die Ausgangsspannung des Oszillators (2.24) gleichzeitig an einem Frequenzteiler (2.25) anliegt, dessen rechteckförmige Ausgangsspannung mit der Frequenz $f_T$ einerseits am Triggereingang des Reglers (3) und andererseits am Eingang eines Integrators (2.26), der die Rechteckspannung in die Dreieckspannung ($U_D$) am zweiten Eingang des Komparators (2.21) umwandelt, anliegt, daß je ein Ausgang des Reglers (3) mit je einem Steuereingang mindestens zweier Umschalter (4.2 bzw. 4.3) verbunden ist, wobei die Umschalter in Abhängigkeit von den Steuerspannungen des Reglers (3) abwechselnd Referenzspannungen ($+U_{ref}$, $-U_{ref}$) durchschalten und damit Hilfskompensationsspannungen ($U_g$, $U_f$) erzeugen, die über Widerstände ($R_3$, $N \times R_3$) im Verhältnis N:1 bewertet das Kompensationssignal ($U_K$) bilden, daß der Regler (3) die Tastverhältnisse der Hilfskompensationsspannungen ($U_g$, $U_f$) so beeinflußt, daß das Nullsignal, dargestellt durch den Mittelwert der Summe aus Meßsignal und Kompensationssignal, zu Null wird.

## Revendications

1. Procédé de conversion d'au moins une tension de mesure en une valeur numérique selon le principe de la poursuite, dans lequel on ajoute un signal de compensation ($U_K$) au siganal de mesure ($U_m$), de sorte qu'en cas d'équilibre, le signal de zéro, représenté par la valeur moyenne de la somme du signal de mesure et du signal de compensation, devient égal à zéro, le signal de compensation étant formé d'au moins deux grandeurs de compensation auxiliaires ($U_g$, $U_f$) évaluées différemment, qui sont des signaux rectangulaires à fréquence fixe et conditions de balayage réglables indépendamment l'un de l'autre, et dont les conditions de balayage, en cas d'écart du signal de zéro par rapport à zéro, sont modifiées de sorte que le signal de zéro revienne à zéro, caractérisé en ce que
- pour un signal de mesure ($U_m$) constant, le signal de zéro est un signal à peu près rectangulaire ayant la forme du signal de somme des grandeurs de compensation auxiliaires ($U_g$, $U_f$), toutefois de façon que sa valeur moyenne à l'état d'équilibre soit nulle, c'est-à-dire que les composantes positives et négatives du signal rectangulaire sont intégrées en fonction du temps dans un intégrateur pour être égales à zéro,
- la tension de sortie ($U_I$) de l'intégrateur est converti avec la fréquence fixe $f_T$ en une valeur d'équilibre de zéro,
- la valeur d'équilibre de zéro est amenée à un régulateur PI ou PID (3), multipliant de manière connue la valeur d'équilibre de zéro par des facteurs P, I ou D, et ajoutant la somme des résultats au signal de compensation déjà existant, et
- la valeur I existant sous la forme d'un signal numérique étant extraite à titre de valeur de la tension de mesure ($U_m$).

2. Procédé selon la revendication 1, caractérisé en ce que les coefficients PI ou PID du régulateur (3) sont modifiés de sorte que selon la résolution exigée on peut atteindre les temps d'amorçage les plus courts et les largeurs de bande de mesure les plus grandes.

3. Procédé selon la revendication 1 ou 2, caractérisé en ce que le régulateur (3) fonctionne en mode non linéaire, c'est-à-dire qu'en fonction de la grandeur de réglage, ses coefficients PI ou PID sont modifiés de sorte qu'il puisse suivre avec une vitesse élevée des variations rapides du signal de mesure pour une résolution diminuée et des modifications plus lentes du signal de mesure pour une résolution en conséquence plus élevée.

4. Procédé selon la revendication 1, caractérisé en ce que, dans le but d'obtenir des largeurs de bande plus grandes, le régulateur (3) est commuté du comportement PI ou PID à un comportement P ou PD, et qu'à la place de la valeur intégrale on extrait la valeur proportionnelle du régulateur (3) comme valeur de mesure.

5. Circuit pour l'exécution du procédé selon l'une des revendications précédentes, caractérisé en ce que la somme du signal de mesure ($U_m$) et du signal de compensation ($U_k$) est placée à l'entrée d'un intégrateur (2.1), dont la sortie est reliée à une entrée d'un comparateur (2.21), à une deuxième entrée duquel est appliquée une tension triangulaire ($U_D$) d'amplitude constante et de fréquence constante ($f_T$), en ce que la sortie du comparateur est reliée à une entrée d'un circuit porte (2.22), à l'autre entrée duquel est appliquée la tension de sortie d'un oscillateur (2.24) de fréquence $f_T$, en ce que la sortie du circuit porte (2.22) est reliée à l'entrée d'un compteur (2.23) dont la sortie numérique est reliée à un régulateur (3), en ce que la tension de sortie de l'oscillateur (2.24) est simultanément appliquée à un diviseur de fréquence (2.25) dont la tension de sortie de forme rectangulaire est appliquée, avec la fréquence $f_T$, d'une part à une entrée de déclenchement du régulateur (3) et d'autre part à l'entrée d'un intégrateur (2.26) qui convertit la tension rectangulaire en tension triangulaire ($U_D$) à la deuxième entrée du comparateur (2.21), en ce que chaque sortie du régulateur (3) est reliée à une entrée de commande d'au moins deux commutateurs (4.2 et 4.3), les commutateurs connectant alternativement, en fonction des tensions de commande du régulateur (3), des tensions de référence (+$U_{ref}$,-$U_{ref}$) et produisent ainsi des tensions de compensation auxiliaires ($U_g$, $U_f$) qui, en étant évaluées dans un rapport N:1 par l'intermédiaire de résistances ($R_3$, $NxR_3$), forment le signal de compensation ($U_K$), en ce que le régulateur (3) exerce une influence sur les conditions de balayage des tensions de compensation auxiliaires ($U_g$, f) de façon que le signal de zéro, représenté par la valeur moyenne de la somme du signal de mesure et du signal de compensation, devienne égal à zéro.

**Claims**

1. A method of converting at least one measured voltage into a digital value on the follow-up principle, wherein a compensating signal ($U_K$) is added to the measured signal ($U_m$) so that in the case of matching, the zero output, represented by the average value of the sum of measured signal and compensating signal, becomes zero, while the compensating signal is formed from at least two differently weighted auxiliary compensating quantities ($U_g$, $U_f$) which are square-wave signals with a fixed frequency and duty cycles which are adjustable independently of one another, and the duty cycles of which are altered, on deviation of the zero output from zero, in such a manner that the zero output returns to zero, characterized in that
- with a constant measured signal ($U_m$), the zero output is approximately a square-wave signal in the form of the aggregate signal of the auxiliary compensating quantities ($U_g$, $U_f$) but in such a manner that its average value in the matched state is zero, that is to say the positive and the negative components of the square-wave signal are integrated over the time in an integrator to become zero,
- the output voltage ($U_I$) of the integrator with the fixed frequency $f_T$ is converted into a zero adjustment value,
- the zero adjustment value is fed to a digital PI or PID controller (3) which multiplies the zero adjustment value by P, I and/or D factors in known manner and adds the sum of the results to the compensating signal already present, and
- the I value present as a digital signal is used as a measure for the measured voltage ($U_m$).

2. A method according to Claim 1, characterized in that the PI or PID coefficients of the controller (3) are altered so that the shortest response times and maximum measured-signal bandwidths are achieved according to the resolution required.

3. A method according to Claim 1 or 2 characterized in that the controller (3) is operated in a non-linear manner, that is to say that its PI or PID coefficients are altered depending on the controlled variable so that it can follow very rapid varation in the measured signal at high speed with reduced resolution and slower variations in the measured signal with correspondingly higher resolution.

4. A method according to Claim 1, characterized in that in order to achieve the maximum measured-signal bandwidths, the controller (3) is switched over from PI or PID action to P or PD action and the proportional value of the controller (3) is used instead of the integral value as the measured value.

5. A circuit arrangement for carrying out the method according to any one of the preceding Claims, characterized in that the sum of measured signal ($U_m$) and compensating signal ($U_K$) is applied to the input of an integrator 2.1, the output of which is connected to the one input of a comparator (2.21), to the second input of which, a delta voltage ($U_D$) of constant amplitude and constant frequency ($f_T$) is applied, that the output of the comparator is connected to the one input of a gate circuit (2.22) to the other input of which the output voltage of an oscillator (2.24) with the frequency $f_T$ is applied, that the output of the gate circuit (2.22) is connected to the input of a counter (2. 23), the digital output of which is connected to a controller (3), that the output voltage of the oscillator (2.24) is simultaneously applied to a frequency divider (2.25), the rectangular output voltage of which, with the frequency $f_T$ is applied on the one hand to the trigger input of the controller (3) and on the other hand to the input of an integrator (2.26) which converts the rectangular voltage into the delta voltage ($U_D$) at the second input of the comparator (2.21), that outputs of the controller (3) are each connected to one control input of at least two change-over switches (4.2 and 4.3), while the change-over switches switch through reference voltages ($+U_{ref}$, $-U_{ref}$) alternately depending on the control voltages of the controller (3) and thus generate auxiliary compensating voltages ($U_g$, $U_f$) which, weighted in the ratio N:1 via resistors ($R_3$, N x $R_3$), from the compensating signal ($U_K$), that the controller (3) influences the duty cycles of the auxiliary compensating voltages ($U_g$, $U_f$) so that the zero output, represented by the average value of the sum of measured signal and compensating signal, becomes zero.

Fig. 1

Fig. 2

Fig. 3

Fig. 4

EP 0 237 583 B1